# EUROPÄISCHE PATENTSCHRIFT

(11) **EP 1 971 874 B1**
(45) Veröffentlichungstag und Bekanntmachung des Hinweises auf die Patenterteilung: **19.12.2018**
(21) Anmeldenummer: 07700186.5
(22) Anmeldetag: 05.01.2007
(51) Int. Cl.: G01R 23/14, G01R 23/173, G01R 35/00, G01R 27/28

(54) **VERFAHREN ZUR DURCHFÜHRUNG EINES FREQUENZWECHSELS**
METHOD FOR CARRYING OUT A FREQUENCY CHANGE
PROCÉDÉ DE CHANGEMENT DE FRÉQUENCE

(30) Priorität: 10.01.2006 DE 102006001284; 15.02.2006 DE 102006007042; 31.03.2006 DE 102006015039
(43) Veröffentlichungstag der Anmeldung: 24.09.2008
(73) Patentinhaber: Rohde & Schwarz GmbH & Co. KG, 81671 München (DE)
(72) Erfinder: ORTIER, Georg, 86459 Gessertshausen (DE)
(74) Vertreter: Körfer, Thomas
(86) Internationale Anmeldenummer: PCT/EP2007/000071
(87) Internationale Veröffentlichungsnummer: WO 2007/080073

(56) Entgegenhaltungen:
- DE-A1- 10 246 700
- DE-A1- 10 331 092
- US-A- 4 647 847
- US-B1- 6 549 862

## Beschreibung

Die Erfindung betrifft ein Verfahren zur Durchführung eines Frequenzwechsels unter Beibehaltung der Phasenbeziehung, insbesondere bei Netzwerkanalysatoren.

Eine Anordnung zur Phasensynchronisation ist aus der DE 103 31 092 A1 bekannt. Bei dieser Anordnung zur Phasensynchronisation sind mehrere Messgeräte, insbesondere Netzwerkanalysatoren, zu einem Messsystem zusammengefasst. Die einzelnen Messgeräte sind über eine Verbindungsleitung so miteinander verbunden, dass die einzelnen Phasenregelschleifen (PLL = phase locked loop) die gleiche Referenzfrequenz erhalten. Eine besondere Vorgehensweise beim Frequenzwechsel, bei welcher die durch die Synchronisation hergestellte definierte Phasenbeziehung erhalten bleibt, ist dort nicht angesprochen.

Aus der DE 102 46 700 A1 ist ein vektorieller Netzwerkanalysator mit steuerbaren Signalgeneratoren und steuerbaren Oszillatoren bekannt. Jede Anregungs-/Empfangseinheit hat zumindest einen eigenen und von dem Signalgenerator getrennten Oszillator, der das Oszillatorsignal für die Mischer der dieser Anregungs-/Empfangseinheit zugeordneten Empfangseinrichtungen erzeugt, so dass die Frequenz und/oder Phase des Oszillatorsignals unabhängig von der Frequenz und/oder Phase der Oszillatorsignale der Oszillatoren der anderen Anregungs-/Empfangseinheiten einstellbar ist. Dadurch ist es möglich die Empfangseinrichtungen mit unterschiedlichen Zwischenfrequenzen zu betreiben. Ein Hinweis darauf, wie mehrere solche Geräte insbesondere beim Frequenzwechsel koordiniert werden können, ist dort jedoch nicht enthalten.

Aus der US 4,647,847 B1 sind ein Verfahren und eine Vorrichtung bekannt wie das Pumpsignal eines harmonischen Mischers mittels eines VCO derart eingestellt werden kann, dass die Zwischenfrequenz die gewünschte Form annimmt. Dies wird mittels eines Zählers, der an einen Mikroprozessor angeschlossen ist, überwacht. Der VCO wird zu Beginn durch einen Controller, der von einem Mikrocontroller gesteuert wird, genau eingestellt. Entspricht die Zwischenfrequenz den angestrebten Werten, so wird der VCO nichtmehr durch einen Controller sondern durch eine PLL-Regelschleife angesteuert.

Aus der DE 103 31 092 A1 ist eine Anordnung zur Phasensynchronisation von mehreren zu einem Messsystem zusammengefassten elektronischen Messgeräten bekannt, beispielsweise Netzwerk- oder Spektrumanalysatoren, die jeweils mindestens einen über eine Phasenregelschleife phasengeregelten Frequenzgenerator aufweisen. Dabei werden die Ausgänge und die Phasensynchronisier-Eingänge dieser Frequenzgeneratoren jeweils über eine Verbindungsleitung miteinander verbunden. Hierzu werden die Ausgänge der Hochfrequenzgeneratoren bzw. Taktgeneratoren der Messgeräte über eine gesonderte Verbindungsleitung zwischen den Messgeräten miteinander und mit dem jeweiligen Phasensynchronisier-Eingang dieser Generatoren verbunden. Durch diese bidirektionale Verbindung wird aus dem jeweiligen Ausgangssignal des Hochfrequenzgenerators des zweiten Messgeräts ein Differenzsignal gebildet, mit dem die Phasenregelschleife der beiden Hochfrequenzgeneratoren entsprechend in der Phase nachgeregelt wird, bis absolute Phasengleichheit besteht und zwar unabhängig von zufälligen Phasenzuständen dieser Phasenregelschleifen der Hochfrequenzgeneratoren nach dem Einschalten, nach einem Frequenzwechsel oder dergleichen Schaltvorgängen.

Aus der US 6,157,183 B1 ist ein tragbarer 2-Tor vektorieller Netzerkanalysator VNA bekannt, mit dem Reflektionen und Transmissionen im Bereich von 25 MHz bis 3,3 GHz gemessen werden können. Weiterhin können Frequenz und Leistungspegel des zu messenden Signals dargestellt werden. Der VNA beinhaltet einen Tracking-Synthesizer der ein lokales Oszillatorsignal generiert und dabei nicht direkt mit einem Referenzoszillator in Verbindung steht, wodurch die Auflösung des lokalen Oszillatorsignals unabhängig von dem erzeugten Hochfrequenztestsignal ist. Ein Verfahren beschreibt, wie die Frequenz und der Leistungspegel in dem zu testenden Frequenzbereich zu messen sind. Hierzu wird der zu messende Frequenzbereich in mehrere Teilbereiche unterteilt und für jeden Teilbereich wird der lokale Oszillator auf eine Eingangsfrequenz gestellt. Im nächsten Schritt wird das Pumpsignal des lokalen Oszillators zusammen mit dem Hochfrequenzsignal einem Mischer zugeführt, der eine Zwischenfrequenz erzeugt. Im Anschluss daran wird die Zwischenfrequenz gefiltert und der Leistungspegel aufgezeichnet. Je nach gewünschter Auflösung des zu messenden Teilbereichs wird die lokale Oszillatorfrequenz geändert und ein neuer Leistungspegel aufgenommen um einen möglichen höheren Leistungspegel zu finden, oder es wird der bisherige Leistungspegel für den Teilbereich ausgegeben.

Der Erfindung liegt daher die Aufgabe zugrunde, ein Verfahren zur Durchführung des Frequenzwechsels zu schaffen, das zuverlässig funktioniert und die Beibehaltung der Phasenbeziehung sicherstellt.

Die Erfindung wird durch das Verfahren zur Durchführung des Frequenzwechsels mit dem Merkmal des Anspruchs 1 gelöst. Die Unteransprüche enthalten vorteilhafte Weiterbildungen der Erfindung.

Oszillatoren aller Geräte zu ändern und die Frequenz der Signalgeneratoren aller Geräte unverändert zu lassen und dann in einem zweiten Schritt nur die Frequenz der zur Anregung aktiven Signalgeneratoren zu ändern und dabei die Frequenz der lokalen Oszillatoren unverändert zu lassen, oder umgekehrt vorzugehen.

Diese zweischrittige Vorgehensweise der ersten Alternative hat den Vorteil, dass beim ersten Schritt die Anregung des Messobjekts unverändert bleibt, da die Frequenz der Signalgeneratoren nicht verändert wird. Bei diesem ersten Schritt eventuell auftretende Änderungen der Phasenlage können daher nicht durch das Messobjekt verursacht sein, sondern müssen durch die Frequenzänderung der lokalen Oszillatoren hervorgerufen worden sein. Diese durch die Frequenzänderung der lokalen Oszillatoren hervorgerufenen Phasenänderungen dürfen in die Messung nicht einfließen und müssen bei der späteren Auswertung entweder eingerechnet werden oder aber durch Änderung der Phasenlage der lokalen Oszillatoren korrigiert bzw. kompensiert werden. Ist der Einfluss des Messobjekts z.B. aufgrund eines gut isolierenden Richtkopplers gering, kann auch umgekehrt vorgegangen werden.

Die Schrittweite des Frequenzwechsels sollte dabei kleiner als die halbe Bandbreite des sich an den Mischer anschließenden Zwischenfrequenzbereichs sein, um sicherzustellen, dass das Signal auch nach der sich ändernden Frequenzablage zwischen dem ersten und zweiten Schritt noch sicher empfangen werden kann.

Um auch größere Frequenzänderungen, beispielsweise beim Rücksprung von der Endfrequenz auf die Startfrequenz eines Sweep-Vorgangs zu ermöglichen, wird bei einer Weiterbildung der Erfindung vorgeschlagen, zunächst bei einem groben Frequenzwechsel nur den ganzzahligen Anteil des Teilungsfaktors der in den Phasenregelschleifen der PLL-Synthesizer üblicherweise vorhandenen Teiler zu ändern. Wird nur der ganzzahlige Anteil des Teilungsfaktors geändert, ändert sich die Phasenlage nicht, so dass insoweit keine Korrektur notwendig ist. Die dann noch nötige Schrittweite für den verbleibenden feinen Frequenzwechsel ist in der Regel kleiner als die halbe Bandbreite des Zwischenfrequenzbereichs. Diese Änderung kann dann wieder so vollzogen werden, dass zunächst nur die Frequenz der lokalen Oszillatoren und erst dann die Frequenz der Signalgeneratoren verändert werden. Es kann auch umgekehrt vorgegangen werden.

Ein Ausführungsbeispiel der Erfindung wird nachfolgend unter Bezugnahme auf die Zeichnung beschrieben. In der Zeichnung zeigen:
- Fig. 1: ein Blockschaltbild einer Anordnung zur Phasensynchronisation, die beim erfindungsgemäßen Verfahren verwendet werden kann;
- Fig. 2: ein Ausführungsbeispiel eines vektoriellen Netzwerkanalysators mit der Phasensynchronisation nach Fig. 1;
- Fig. 3: ein Ausführungsbeispiel einer Phasensynchronisastions-Einheit zur Synchronisation einer Referenzfrequenz und eines Taktsignals;
- Fig. 4: ein Ausführungsbeispiel eines lokalen Oszillators, welcher für die erfindungsgemäße Phasensynchronisation verwendet werden kann;
- Fig. 5: ein Diagramm zur Erläuterung des Frequenzwechsels und
- Fig. 6: ein Diagramm zur Erläuterung des Zusammenhangs zwischen der Schrittweite beim Frequenzwechsel und der Zwischenfrequenzbandbreite.

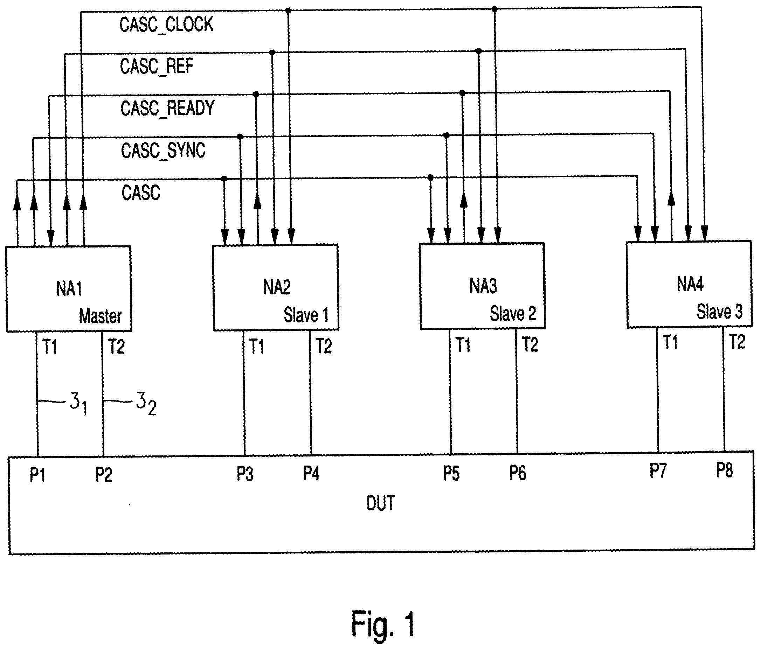

Bevor auf das erfindungsgemäße Verfahren eingegangen wird, soll zunächst anhand der Figuren 1 bis 4 eine Anordnung zur Phasensynchronisation beschrieben werden, die sich zur Durchführung des erfindungsgemäßen Verfahrens eignet.

Fig. 1 zeigt ein überblickartiges Blockschaltbild der Anordnung zur Phasensynchronisation. Mehrere Messgeräte, beispielsweise Netzwerkanalysatoren NA1, NA2, NA3, NA4 aber auch beispielsweise Spektrumanalysatoren, sollen zu einem Messgeräteverbund zusammengeschaltet werden. Dies ist beispielsweise deshalb notwendig, weil die einzelnen Messgeräte, insbesondere Netzwerkanalysatoren, jeweils nur zwei Messtore T1 und T2 haben, das Messobjekt (DUT = device under test) jedoch mehrere Eingangs- und Ausgangstore P1, P2, P3, P4, P5, P6, P7 und P8 hat, welche gleichzeitig zu vermessen sind. Dabei soll eine exakte Messung der Phasenlage der Messsignale in Bezug auf die Phasenlage der Anregungssignale erreicht werden. Beispielsweise könnte das Messobjekt DUT an seinen Toren P1 und P2 durch einen ersten Netzwerkanalysator NA1 durch ein differentiales Signal (differential mode) angeregt werden, wobei im differential mode die an den Toren T1 und T2 des Netzwerkanalysators NA1 zu erzeugenden Signale einen exakten Phasenunterschied von 180° haben müssen. Die anderen Tore P3 bis P8 können beispielsweise Ausgangstore des Messobjekts sein, wobei es an jedem Tor P3 bis P8 darauf ankommt, die exakte Phasenlage in Bezug auf das Anregungssignal zu messen.

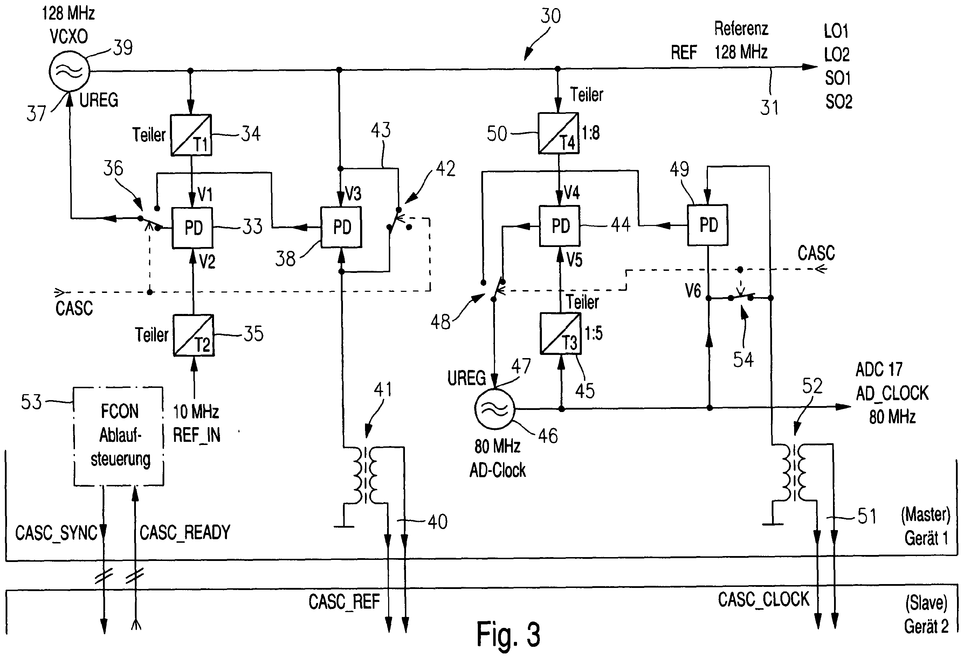

Um dies zu erreichen, werden eines der Messgeräte, im in Fig. 1 gezeigten Beispiel das Messgerät NA1, als Haupt-Gerät (Master) betrieben und die anderen Messgeräte, im in Fig. 1 gezeigten Beispiel die Messgeräte NA2, NA3, NA4, als dem Haupt-Gerät NA1 untergeordnete Geräte (Slaves) betrieben. Dazu teilt zunächst das Haupt-Gerät NA1 über das Signal CASC den anderen Geräten NA2 bis NA4 mit, dass es eine Zusammenschaltung (Kaskadierung) wünscht und es bei dieser Messaufgabe das übergeordnete Gerät (Master) sein wird. Daraufhin werden die anhand von Fig. 3 noch zu erläuternden Umschalteinrichtungen in den einzelnen Messgeräten in die entsprechende Schaltstellung gebracht.

Durch die Anfrage CASC_SYNC fragt das Haupt-Gerät NA1 die untergeordneten Geräte NA2 bis NA4 ab, ob der Umschaltvorgang beendet ist. Die Geräte NA2 bis NA4 bestätigen dies über das Signal CASC-READY. In dieser Konfiguration versorgt das Haupt-Gerät NA1 die untergeordneten Geräte NA2 bis NA4 mit einem Referenzsignal CASC_REF und im dargestellten bevorzugten Ausführungsbeispiel zusätzlich mit einem Takt-Signal CASC_CLOCK.

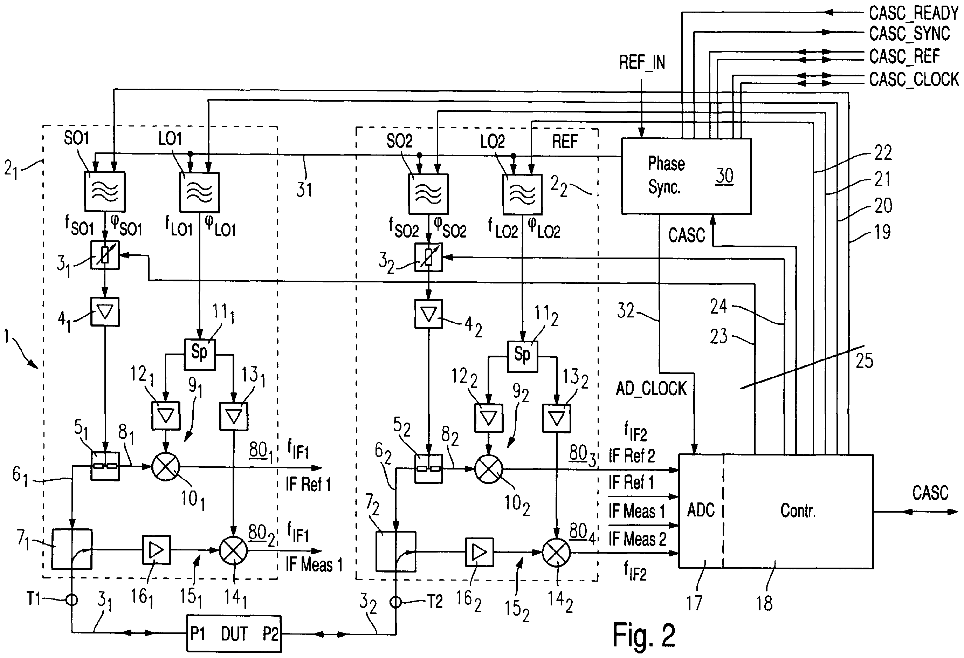

Zum besseren Verständnis dafür, warum das Referenzsignal CASC_REF und das Referenz-Taktsignal CASC_CLOCK benötigt wird, ist in Fig. 2 ein Beispiel für den internen Aufbau eines Netzwerkanalysators angegeben. Nach dem in Fig. 2 dargestellten Blockschaltbild können die in Fig. 1 dargestellten Netzwerkanalysatoren NA1 bis NA4 intern aufgebaut sein.

Fig. 2 zeigt ein Ausführungsbeispiel einer der Messvorrichtungen NA1 - NA4, bei welcher die Phasensynchronisation benutzt wird. Im gezeigten Ausführungsbeispiel handelt es sich bei den Messvorrichtungen um einen vektoriellen Netzwerkanalysator. Die Messvorrichtung ist jedoch nicht auf Netzwerkanalysatoren eingeschränkt. Dargestellt ist das Ausführungsbeispiel des 2-Tor-Netzwerkanalysators NA1. Dabei ist hervorzuheben, dass das Phasensynchronisations-Konzept bei vektoriellen Netzwerkanalysatoren nicht auf 2-Tor-Netzwerkanalysatoren beschränkt ist, sondern sich auch bei Mehrtor-Netzwerkanalysatoren mit mehr als zwei Messtoren eignet.

Bei dem dargestellten Ausführungsbeispiel ist an jedem Tor T1, T2 des Netzwerkanalysators NA1 eine separate Anregungs-/Empfangseinheit 2₁ bzw. 2₂ vorhanden. Jede Anregungs-/Empfangseinheit 2₁ bzw. 2₂ verfügt über einen Signalgenerator SO1 bzw. SO2, mit welchem das Messobjekt DUT mit einem Anregungssignal beaufschlagbar ist. Es kann entweder nur einer der beiden Signalgeneratoren SO1 bzw. SO2 aktiv sein oder es können auch beide Signalgeneratoren SO1 und SO2 jeweils ein Anregungssignal aussenden.

Im in Fig. 1 dargestellten Anwendungsfall ist das Messobjekt DUT ein 8-Tor. Jedes der beiden ersten Tore P1 und P2 des Messobjekts DUT ist über eine Messleitung 3₁ bzw. 3₂ mit einem der beiden Tore T1 bzw. T2 des ersten Netzwerkanalysators NA1 verbunden.

Die Signalgeneratoren SO1 und S02 sind jeweils über ein variables Dämpfungsglied 3₁ bzw. 3₂ und jeweils einen Verstärker 4₁ bzw. 4₂ mit einem Signal-Verteiler (signal splitter) 5₁ bzw. 5₂ verbunden. Ein Signalzweig 6₁ bzw. 6₂ steht jeweils über eine Brücke (z.B. Richtkoppler) 7₁ bzw. 7₂ mit dem zugeordneten Tor T1 bzw. T2 in Verbindung. Der andere Zweig 8₁ bzw. 8₂ ist mit einem Mischer 10₁ bzw. 10₂ einer ersten Empfangseinrichtung 9₁ bzw. 9₂ der jeweiligen Anregungs-/Empfangseinheit 2₁ bzw. 2₂ verbunden. Die erste Empfangseinrichtung 9₁ bzw. 9₂ empfängt somit, wenn der zugehörige Signalgenerator SO1 bzw. SO2 aktiv ist, das Anregungssignal. Ferner wird dem Mischer 10₁ bzw. 10₂ ein Oszillatorsignal zugeführt, das von einem internen Oszillator LO1 bzw. LO2 der jeweiligen Anregungs-/Empfangseinheit 2₁ bzw. 2₂ erzeugt wird und dem Mischer 10₁ bzw. 10₂ über einen Signal-Verteiler (signal splitter) 11₁ und 11₂ und jeweils einen Verstärker 12₁ bzw. 12₂ zugeführt wird.

Der gleiche Oszillator LO1 bzw. LO2 versorgt über den anderen Signalzweig der Signal-Verteiler 11₁ bzw. 11₂ und einen entsprechenden Verstärker 13₁ bzw. 13₂ einen Mischer 14₁ bzw. 14₂ einer zweiten Empfangseinrichtung 15₁ bzw. 15₂ der jeweiligen Anregungs-/Empfangseinheit 2₁ bzw. 2₂. Der Mischer 14₁ bzw. 14₂ steht über einen Isolations-Verstärker 16₁ bzw. 16₂ und die Brücke 7₁ bzw. 7₂ mit dem zugeordneten Tor T1 bzw. T2 in Verbindung. Somit erhält die zweite Empfangseinrichtung 15₁ das von dem zugehörigen Tor T1 empfangene, von dem Messobjekt zum Tor T1 reflektierte oder durch das Messobjekt DUT von dem Tor T1 zum Tor T2 transmittierte Signal. Entsprechend empfängt die zweite Empfangseinrichtung 15₂ der Anregungs-/Empfangseinheit 2₂ das von dem Messobjekt DUT zum Tor T2 reflektierte oder durch das Messobjekt DUT vom Tor T1 zum Tor T2 transmittierte Signal. Die Mischer 10₁ und 14₁ der ersten Anregungs-/Empfangseinheit 2₁ setzen das empfangene Signal in eine erste Zwischenfrequenzlage mit der Zwischenfrequenz f_{IF1} um, während die Mischer 10₂ und 14₂ der zweiten Anregungs-/Empfangseinheit 2₂ das empfangene Signal in eine zweite Zwischenfrequenzlage mit der Zwischenfrequenz f_{IF2} umsetzen. Dabei sind die Zwischenfrequenzen f_{IF1} und f_{IF2} nicht notwendigerweise identisch.

Das von den Mischern 10₁ bzw. 10₂ erzeugte Zwischenfrequenz-Referenzsignal IF Ref 1 bzw. IF Ref 2 sowie das von den Mischern 14₁ bzw. 14₂ erzeugte Zwischenfrequenz-Messsignal IF Meas 1 bzw. IF Meas 2 wird einem Analog/Digital-Wandler 17 zugeführt, welcher mit einer Signalauswertungs- und Steuereinheit 18 in Verbindung steht. In dieser erfolgt eine Auswertung der Referenzsignale und der Messsignale. Die Signalauswertungs- und Steuereinheit 18 steuert ferner über Steuerleitungen 19, 20, 21 und 22 die Signalgeneratoren SO1 und SO2 sowie die Oszillatoren LO1 und LO2 so an, dass diese ein Signal mit vorbestimmter Frequenz f_{SO1}, f_{LO1}, f_{SO2} bzw. f_{LO2} und mit vorbestimmter Phase ϕ_{SO1}, ϕ_{LO1}, ϕ_{SO2} und ϕ_{LO2} erzeugen.

Über weitere Steuerleitungen 23 und 24 steht die Auswerte- und Steuereinheit 18 mit den einstellbaren Dämpfungsgliedern 3₁ und 3₂ in Verbindung, so dass die Signalamplitude des von den Signalgeneratoren SO1 und SO2 erzeugten Anregungssignals steuerbar ist. Da die Ist-Amplitude des Anregungssignals über die Zwischenfrequenz-Referenzsignale IF Ref 1 und IF Ref 2 erfaßt werden, kann auf diese Weise eine Regelschleife zur exakten Regelung der Anregungsamplitude gebildet werden.

Die Steuerleitungen 19 bis 23 können zu einem Bus-System 25, insbesondere einem LAN-Bus-System, zusammengefasst werden. Durch unterschiedliche Einstellung der Phasen ϕ_{LO1}, ϕ_{LO2} bzw. ϕ_{SO1}, ϕ_{SO2} können Laufzeitunterschiede, beispielsweise in den Messleitungen 3₁ und 3₂ ausgeglichen werden.

Es sei nochmals betont, dass die erfindungsgemäße Weiterbildung sich nicht nur auf Netzwerkanalysatoren bezieht, sondern auch in anderen Messvorrichtungen sinnvoll ist.

Der in Fig. 2 dargestellte Netzwerkanalysator hat eine Phasensynchronisationseinheit 30, die von den Netzwerkanalysatoren die anhand der in Fig. 1 beschriebenen Signale CASC_READY, CASC_SYNC, CASC_REF und CASC_CLOCK empfängt bzw. an diese aussendet. In der Steuereinheit 18 wird festgelegt, ob der jeweilige Netzwerkanalysator übergeordnet (Master) oder untergeordnet (Slave) ist. Beispielsweise kann die Bedienperson an dem jeweiligen Netzwerkanalysator eingeben, dass dieser Netzwerkanalysator NA1 das übergeordnete Haupt-Gerät (Master) sein soll. Dieser Netzwerkanalysator NA1 sendet dann das Signal CASC an die übrigen Netzwerkanalysatoren NA1 - NA4, die daraufhin wissen, dass sie die untergeordneten Netzwerkanalysatoren (Slaves) bei der anstehenden Messaufgabe sind. Außerdem wird das Signal CASC an die Phasensynchronisationseinheit 30 gesandt, wo daraufhin Umschalteinrichtungen betätigt werden, die noch später anhand der Fig. 3 erläutert werden.

Über eine Verbindungsleitung 31 steht die Phasensynchronisationseinheit 30 mit den Signalgeneratoren SO1 und SO2 sowie den lokalen Oszillatoren LO1 und LO2 in Verbindung und gibt diesen ein Haupt-Referenzsignal REF vor. Mit dem Analog/Digital-Wandler 17 steht die Phasensynchronisationseinheit 30 über eine Verbindungsleitung 32 in Verbindung und übermittelt an diese das Taktsignal AD_CLOCK zur Festlegung der Abtastzeit. Das zur Erzeugung des Haupt-Referenzsignals REF benötigte Hilfs-Referenzsignal REF_IN kann entweder extern zugeführt werden oder innerhalb des Netzwerkanalysators erzeugt werden.

Fig. 3 zeigt als Blockschaltbild ein Ausführungsbeispiel des Aufbaus der Phasensynchronisations-Einheit 30. Ein steuerbarer Oszillator 39 erzeugt das Haupt-Referenzsignal REF. Ein erster Phasendetektor 33 empfängt ein erstes Vergleichssignal V2. Im dargestellten Ausführungsbeispiel ist das erste Vergleichssignal V1 aus dem Haupt-Referenzsignal REF dadurch abgeleitet, dass die Frequenz des Haupt-Referenzsignals in einem ersten Teiler 34 durch einen ersten Teilerfaktor T1 geteilt wird. Das zweite Vergleichssignal V2, dessen Phase mit der Phase des ersten Vergleichssignals V1 verglichen wird, wird aus dem Hilfs-Referenzsignal REF_IN abgeleitet. Dazu wird im dargestellten Ausführungsbeispiel die Frequenz des Hilfs-Referenzsignals REF_IN in einem zweiten Teiler 35 durch einen zweiten Teilerfaktor T2 geteilt. Am Ausgang des ersten Phasendetektors 33 entsteht somit ein Regelsignal, welches ein Maß für die Phasenabweichung zwischen den beiden Vergleichssignalen V1 und V2 ist. Dieses ist über eine erste Umschalteinrichtung 36 als Regelsignal UREG einem Regeleingang 34 des Oszillators 39 zuführbar.

Die in Fig. 3 dargestellte Schaltstellung entspricht der Situation, dass das der Phasensynchronisationseinheit 30 zugeordnete Gerät NA1 das Haupt-Gerät (Master) ist. In dieser Situation schaltet die erste Umschalteinrichtung 36 den Ausgang des ersten Phasendetektors 33 auf den Regeleingang 37 des geregelten Oszillators 39. Ist das zugehörige Gerät jedoch ein untergeordnetes Gerät (Slave), so befindet sich die erste Umschalteinrichtung 36 in der oberen Schaltstellung und verbindet den Ausgang eines zweiten Phasendetektors 38 mit dem Regeleingang 37 des Oszillators 39.

Das erste Vergleichssignal V3, das dem zweiten Phasendetektor 38 zugeführt wird, ist das Haupt-Referenzsignal REF. Das andere Vergleichssignal ist das Haupt-Referenzsignal des Haupt-Geräts, welches im Ausführungsbeispiel über eine Zweidraht-Verbindungsleitung 40 und einen Transformator 41 dem anderen Eingang des zweiten Phasendetektors 38 zugeführt wird. Eine zweite Umschalteinrichtung 42 schließt die Verbindungsleitung 43 nur dann, wenn das zugehörige Gerät das Haupt-Gerät (Master) ist. Wenn das Gerät ein untergeordnetes Gerät (Slave) ist, so ist die Leitung 43 geöffnet; in diesem Fall findet somit ein Phasen-Vergleich zwischen dem Haupt-Referenzsignal REF und dem von dem Haupt-Gerät zugeführten Referenzsignal CASC_REF statt.

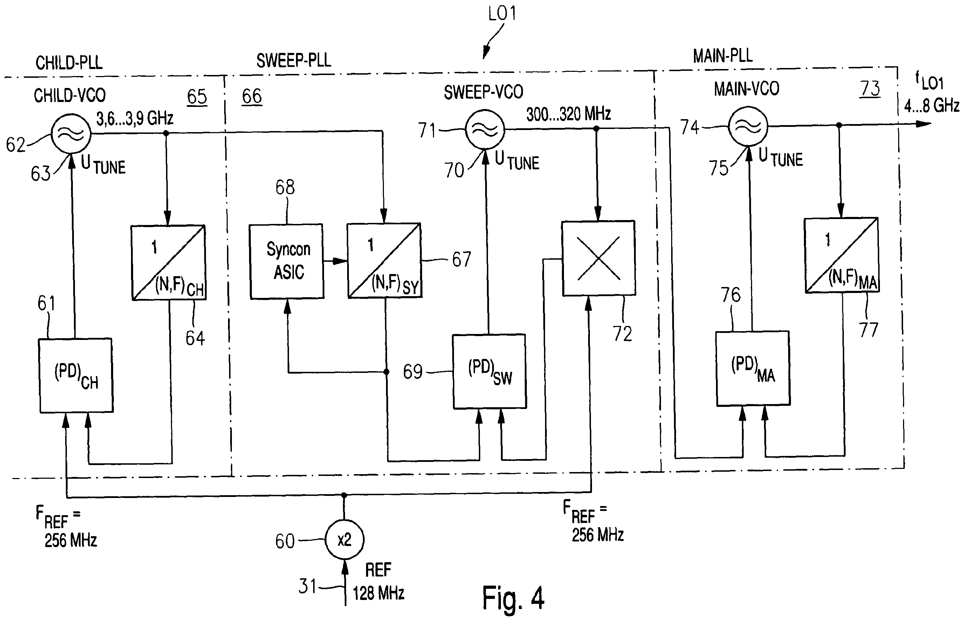

In der in Fig. 3 gezeigten Schaltstellung für den Master-Betrieb besteht somit eine geschlossene Phasen-Schleife vom Ausgang des Oszillators 39 über den Teiler 34, den Phasendetektor 33 zum Regeleingang 37 des Oszillators 39, wobei der Phasenvergleich mit dem Hilfs-Referenzsignal REF_IN erfolgt. Bei dem Slave-Betrieb hingegen besteht eine geschlossene Phasenschleife vom Ausgang des Oszillators 39 über den zweiten Phasendetektor 38 zum Regeleingang 37 des Oszillators 39, wobei der Phasenvergleich dann mit dem Haupt-Referenzsignal REF des Master-Geräts erfolgt. Auf diese Weise ist sichergestellt, dass die Phasenregelschleifen aller Geräte synchron zueinander arbeiten und die Oszillatoren 39 aller Geräte phasensynchrone Referenzsignale REF erzeugen, die den jeweiligen Signalgeneratoren SO1, SO2 und lokalen Oszillatoren LO1, LO2 der jeweiligen Geräte zugeführt werden, die dann ebenfalls synchron zueinander arbeiten, was später anhand von Fig. 4 genauer beschrieben wird.

Eine weitere Aufgabe der Phasensynchronisations-Einheit 30 besteht bei einem bevorzugten Ausführungsbeispiel darin, für die Synchronität der Taktsignale der Analog/DigitalWandler zu sorgen. Hierzu ist ein dritter Phasendetektor 44 vorhanden, der die Phase eines vierten Vergleichssignals V4 mit der Phase eines fünften Vergleichssignals V5 vergleicht. Das fünfte Vergleichssignal V5 wird über einen dritten Teiler 45 aus dem Taktsignal AD_CLOCK abgeleitet, wobei der dritte Teiler 45 die Frequenz des Taktsignals AD_CLOCK durch einen dritten Teilerfaktor T3 teilt. Das vierte Vergleichssignal V4 ist über einen vierten Teiler 50 aus dem Haupt-Referenzsignal REF abgeleitet, wobei der vierte Teiler 50 die Frequenz des Haupt- Referenzsignals REF durch den Teilungsfaktor T4 teilt. Das Taktsignal AD_CLOCK für die Analog/Digital-Wandler 17 wird mittels eines zweiten Oszillators 46 erzeugt, dessen Regeleingang 47 über eine dritte Umschalteinrichtung 48 mit dem Ausgang des dritten Phasendetektors 44 verbindbar ist. Über das Signal CASC ist diese Verbindung nur für den Fall geschaltet, dass das betreffende Gerät das Haupt-Gerät (Master) ist. Für den Fall, dass es sich bei dem Gerät um ein untergeordnetes Gerät (Slave) handelt, schaltet die dritte Umschalteinrichtung 48 den Regeleingang 47 des zweiten Oszillators 46 auf den Ausgang eines vierten Phasendetektors 49.

Für den Fall, dass es sich bei dem Gerät um ein untergeordnetes Gerät (Slave) handelt, verbindet die dritte Umschalteinrichtung 48 den Regeleingang 47 des zweiten Oszillators 46 jedoch mit dem Ausgang eines vierten Phasendetektors 49. Eines der Vergleichssignale, die dem vierten Phasendetektor 49 zugeführt werden, ist das von dem zweiten Generator 46 erzeugte Taktsignal AD_CLOCK. Das andere Vergleichssignal ist das Taktsignal CASC_CLOCK, welches von dem Master-Gerät über die Zweidraht-Verbindungsleitung 51 und den Transformator 52 zugeführt wird. Eine vierte Umschalteinrichtung 54 ist nur geschlossen, wenn das jeweilige Gerät das Master-Gerät ist. Dadurch wird dafür gesorgt, dass das von diesem Master-Gerät erzeugte Taktsignal AD_CLOCK über die Zweidrahtleitung als 50 als Taktsignal CASC_CLOCK an die untergeordneten Geräte (Slaves) übertragen wird und dort zur Synchronisation der Takt-Signale herangezogen werden kann. Somit sind alle durch die jeweiligen Phasensynchronisationseinheit 30 in den jeweiligen Geräten erzeugten Taktsignale AD_CLOCK miteinander synchronisiert.

Auch hier wird eine erste abgeschlossene Phasenregelschleife durch den zweiten Oszillator 46, den dritten Teiler 45 und den dritten Phasendetektor 44 geschaffen, wenn das jeweilige Gerät das Master-Gerät ist, wobei diese Phasenregelschleife auf das Haupt-Referenzsignal REF synchronisiert. Alternativ wird eine zweite geschlossene Phasenregelschleife durch den Generator 46 und den vierten Phasendetektor 49 geschaffen, wenn das jeweilige Gerät das Slave-Gerät ist, wobei in diesem Fall auf das externe Takt-Signal CASC_CLOCK synchronisiert wird.

Des Weiteren ist bevorzugt eine Ablaufsteuerung 53 vorhanden. Die Ablaufsteuerung 53 des Master-Geräts sendet den Befehl CASC_SYNC an alle Slave-Geräte, die daraufhin die Umschalteinrichtungen 36, 42, 48 und 54 betätigen. Die vollzogene Umschaltung wird durch das Signal CASC_READY an das Master-Gerät bestätigt.

Fig. 4 zeigt eine mögliche Realisierung eines der lokalen Oszillatoren LO1. Im Rahmen der Erfindung sind auch beliebig andere Realisierungen möglich. Anhand von Fig. 4 soll lediglich eine mögliche Verwendung des Haupt-Referenzsignals REF veranschaulicht werden.

Das Haupt-Referenzsignals REF wird von der Phasensynchronisationseinheit 30 an den lokalen Oszillator LO1 über die Verbindungsleitung 31 übertragen. In dem Ausführungsbeispiel wird in dem lokalen Oszillator LO1 zunächst die Frequenz des Haupt-Referenzsignals REF in einem Frequenzverdoppler 60 verdoppelt und innerhalb des lokalen Oszillators LO1 einem ersten Vergleichseingang ersten Phasendetektor 61 zugeführt. Des Ausgang des Phasendetektors 61 ist mit dem Regeleingang 63 eines ersten Oszillators 62 verbunden. Der Ausgang des ersten Oszillators 62 ist über einen ersten fraktionalen Teiler 64 mit dem zweiten Vergleichseingang des ersten Phasendetektors 61 verbunden. Folglich bildet der erste Oszillator 62 mit dem Teiler 64 und dem ersten Phasendetektor 61 eine erste PLL-Regelschleife, welche mit dem Haupt-Referenzsignal REF synchronisiert wird. Diese erste PLL-Regelschleife im Abschnitt 65 wird auch als Child_PLL bezeichnet. Der Teiler 64 teilt die Frequenz durch den gebrochenrationalen Teilungsfaktor (N,F)_{CH} mit dem ganzzahligen Anteil N und dem nicht ganzzahligen Nachkomma-Anteil F.

Der sich daran anschließende Abschnitt 66 wird als Sweep_PLL bezeichnet. Dort ist ein zweiter Teiler 67 vorhanden, der mit dem Ausgang des ersten Oszillators 62 in Verbindung steht. Ein Synchronbaustein 68 sorgt für die Auswahl des gebrochenrationalen Teilungsfaktors (N,F)_{SY} des Teilers 67. Der Ausgang des zweiten Teilers 67 steht mit einem ersten Vergleichseingang eines zweiten Phasendetektors 69 in Verbindung. Dessen Ausgang steht wiederum mit dem Regeleingang 70 eines zweiten Oszillators 71 in Verbindung. Der Ausgang des zweiten Oszillators 71 ist mit einem ersten Eingang eines Mischers 72 verbunden. Ein zweiter Eingang des Mischers 72 empfängt das von dem Frequenzverdoppler 60 verdoppelte Haupt-Referenzsignal REF. Der Ausgang des Mischers 72 steht mit dem zweiten Vergleichseingang des zweiten Phasendetektors 69 in Verbindung. Auf diese Weise wird durch den zweiten Oszillator 71, den Mischer 72 und den Phasendetektor 69 eine zweite PLL-Regelschleißfe gebildet, der auch über das Haupt-Referenzsignal REF synchronisiert ist.

In einem dritten Abschnitt 73, der als MAIN_PLL bezeichnet wird, befindet sich ein dritter Oszillator 74, dessen Regeleingang 75 mit einem dritten Phasendetektor 76 verbunden ist. Ein erster Vergleichseingang des dritten Phasendetektors 76 steht mit dem Ausgang des zweiten Oszillators 71 in Verbindung, während ein zweiter Vergleichseingang des dritten Phasendetektors 76 über einen dritten Teiler 77 mit dem Ausgang des dritten Oszillators 74 verbunden ist. Am Ausgang des dritten Oszillators 74, der auch als Haupt-Oszillator bezeichnet werden kann, steht das lokale Oszillator-Signal mit der Frequenz f_{LO1} zu Verfügung. Die Frequenz f_{LO1} ist dabei über eine Oktav, im Ausführungsbeispiel von 4 GHz bis 8 GHz, abstimmbar. Der Teiler 77 teilt die Frequenz ebenfalls durch einen gebrochenrationalen Teilungsfaktor (N,F)_{MA}.

Durch die Phasensynchronisations-Einheit 30 wird bei jedem der miteinander verbundenen Geräte eine Synchronisation der Signalgeneratoren SO und der lokalen Oszillatoren LO hergestellt. Gleichzeitig wird eine Synchronisation der Abtastraten der Analog/Digital-Wandler 17 erreicht. Auf Grund der klaren Unterordnung der Slave-Geräte unter das eine Master-Gerät ergeben sich kurze Regelzeiten bzw. Einschwingzeiten.

Die vorliegende Erfindung beschäftigt sich damit, wie bei der Zusammenschaltung mehrerer Messgeräte, insbesondere Netzwerkanalysatoren, die beispielsweise mit einer Phasensynchronisiereinrichtung ausgestattet sein können, wie dies vorstehend anhand der Figuren 1 bis 4 beschrieben wurde, diese so betrieben werden können, dass bei einem Frequenzwechsel die Phasensynchronisation erhalten bleibt. Es soll aber betont werden, dass die Phasensynchronisation nicht notwendiger Weise wie vorstehend beschrieben hergestellt worden sein muss; es eignet sich zur Phasensynchronisation auch jedes andere bekannte Verfahren, z. B. jenes nach der DE 103 31 092 A1.

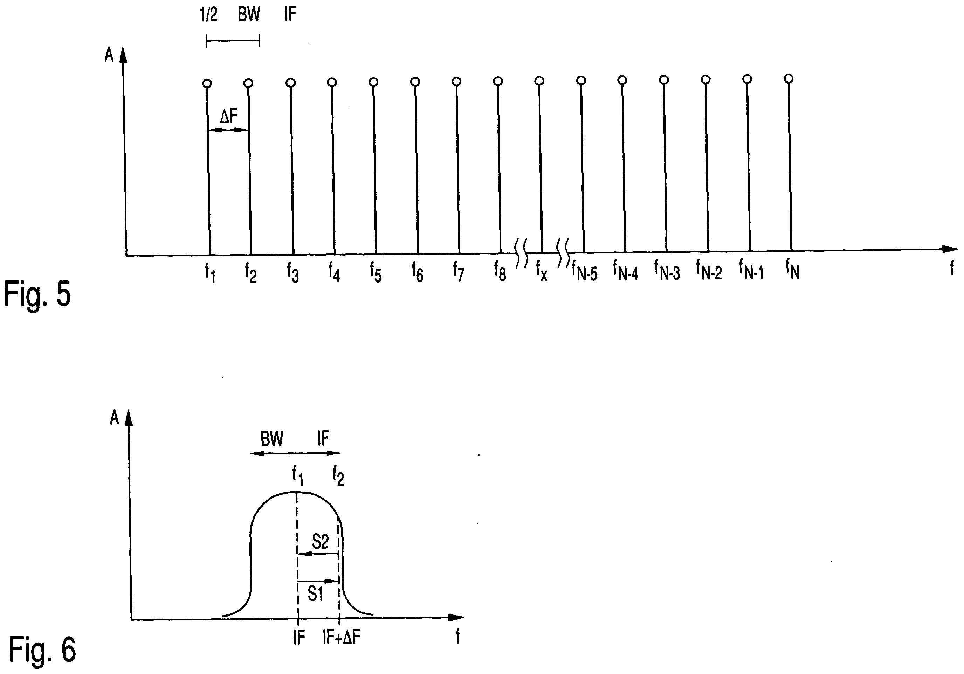

Üblicherweise wird zunächst eine Kalibriermessung durchgeführt, bei welcher die Phasenbeziehung anhand von Kalibrierstandards ermittelt wird, und der Kalibrierstandard wird dann durch das zu vermessende, unbekannte Messobjekt DUT ersetzt. Das Messobjekt soll bei einer Vielzahl von Messfrequenzen vermessen werden. Wie in Fig. 5 gezeigt, wird dazu das Frequenzintervall, in welchem die Messgrößen, beispielsweise die S-Parameter, interessieren, in N-Frequenzpunkte zwischen einer Startfrequenz f. und einer Endfrequenz f_{N} aufgeteilt. In der Regel werden äquidistante Abstände ΔF zwischen den Frequenz-Stützstellen f_{I} verwendet.

Wenn bei der Startfrequenz f₁ über Kalibrierstandards ein Phasenabgleich hergestellt wurde, der über die vorstehend anhand der Figuren 1 bis 4 beschriebenen Maßnahmen zwischen den einzelnen Netzwerkanalysatoren NA1 bis NA4 über die dortigen Phasensynchronisationseinheiten 30 aufrechterhalten wird, so stellt sich das Problem, wie diese Phasensynchronisation bei einem Wechsel von der Messfrequenz f₁ auf die nächsthöhere Messfrequenz f₂ aufrechterhalten werden kann. Hier setzt die vorliegende Erfindung ein.

Bei einem Frequenzwechsel müssen sowohl die Frequenzen f_{SO1} bzw. f_{SO2} der bei der Anregung aktiven Signalgeneratoren SO1 bzw. S02 all derjenigen Geräte, die zumindest ein Tor P1 bis P8 des Messobjekts DUT mit einem Anregungssignal anregen, verändert werden, als auch die Frequenz f_{LO1} bzw. f_{LO2} sämtlicher lokaler Oszillatoren LO1 bzw. L02 sämtlicher Geräte an allen Toren, die ein von dem Messobjekt DUT reflektiertes oder durch dieses transmittiertes Messsignal empfangen. Dabei müssen die Frequenzen f_{SO1} bzw. f_{SO2} der Signalgeneratoren SO1 bzw. SO2 um die gleiche Schrittweite ΔF verändert werden, wie die Frequenzen f_{LO1} bzw. f_{LO2} der lokalen Oszillatoren LO1 bzw. LO2, denn es muss sichergestellt werden, dass die resultierende Zwischenfrequenz f_{IF1} bzw. f_{IF2} sich bei dem Frequenzwechsel letztendlich nicht ändert, d.h., dass das zu erwartende Messsignal in die Mitte der Durchlassbandbreite des sich an die Mischer 10₁, 10₂ bzw. 14₁ und 14₂ anschließenden Zwischenfrequenzbereichs 80₁, 80₂, 80₃ bzw. 80₄ fällt.

Werden dabei jedoch die Frequenzen f_{SO1} bzw. f_{SO2} der Signalgeneratoren SO1 bzw. SO2 und die Frequenzen f_{LO1} bzw. f_{LO2} der lokalen Oszillatoren LO1 bzw. LO2 gleichzeitig verändert, so kann die Phasensynchronisation nicht aufrechterhalten werden. Erfindungsgemäß wird daher vorgeschlagen, zunächst nur die Frequenzen f_{LO1} bzw. f_{LO2} zu verändern und bei diesem Schritt die Frequenzen f_{SO1} bzw. f_{SO2} der Signalgeneratoren SO1 bzw. SO2 unverändert zu belassen. Dies hat den Vorteil, dass sich die Anregung des Messobjekts DUT in diesem ersten Schritt des Frequenzwechsels nicht verändert und daher eine bei diesem ersten Schritt des Frequenzwechsels eventuell auftretende Phasenänderung nicht von dem Messobjekt DUT herrühren kann, sondern dass seine alleinige Ursache in der Frequenzänderung der Oszillatorfrequenzen f_{LO1} bzw. f_{LO2} haben kann. In diesem ersten Schritt werden die Frequenzen sämtlicher lokaler Oszillatoren sämtlicher zu der Messprozedur zusammengeschalteten Geräte geändert, also die Frequenzen der Lokaloszillatoren sämtlicher Geräte, die Messsignale empfangen.

Die bei diesem ersten Schritt auftretende Phasenänderung, welche von der Frequenzänderung der lokalen Oszillatoren herrührt, ist nun bekannt und kann entweder korrigiert bzw. kompensiert werden oder bei der späteren Auswertung des Messergebnisses eingerechnet werden. Zur Korrektur kann bei dem in Fig. 2 dargestellten Ausführungsbeispiel die durch die Steuereinheit 18 vorgebbare Phase ϕ_{LO1} bzw. ϕ_{LO2} so variiert werden, dass der Phasenzustand vor dem ersten Schritt des Frequenzwechsels wieder erreicht wird. Soll die bei dem ersten Schritt auftretende Phasenänderung nicht korrigiert werden, sondern bei einer späteren Auswertung berücksichtigt werden, empfiehlt es sich, diese Phasenänderung in einem Speicher festzuhalten.

Erst jetzt erfolgt in einem zweiten Schritt die Änderung der Frequenz f_{SO1} bzw. f_{SO2} der bei der konkreten Messaufgabe aktiven Signalgeneratoren SO1 bzw. SO2. Wird das in Fig. 1 dargestellte Messobjekt DUT z.B. an seinen Toren P1 und P2 durch den ersten Netzwerkanalysator NA1 durch ein differentielles Signal (differential mode) angeregt, so sind bei diesem zweiten Schritt nur die Signalgeneratoren SO1 und SO2 des ersten Netzwerkanalysators NA1 in ihrer Frequenz zu verändern. Die Signalgeneratoren der anderen Netzwerkanalysatoren NA2, NA3 und NA4 sind bei dieser Messaufgabe nicht aktiv, sondern abgeschaltet und müssen daher auch nicht verändert werden. Bei diesem zweiten Schritt ändert sich die Anregung des Messobjekts DUT. Diese Änderung der Anregung kann zu Phasenänderungen führen, die aber gerade gemessen werden sollen. Handelt es sich beispielsweise bei dem Messobjekt um ein Bandpassfilter, so ändert sich an den Flanken des Bandpassfilters die Phase mit der Änderung der Frequenz gravierend. Diese Phasenänderung findet ihren Niederschlag z.B. in den zu messenden komplexen S-Parametern.

Durch die erfindungsgemäße zweischrittige Vorgehensweise können diejenigen Phasenänderungen, die durch eine Änderung der Oszillatorfrequenzen hervorgerufen werden, von denjenigen Phasenänderungen, die durch eine Änderung der Frequenzen der Signalgeneratoren und somit durch eine Änderung der Anregung des Messobjekts DUT hervorgerufen werden, getrennt werden. Die durch die Änderung der Frequenzen der lokalen Oszillatoren hervorgerufenen Phasenänderungen sollen in dem Messergebnis keinen Niederschlag finden und können entweder korrigiert bzw. kompensiert werden oder aus dem Messergebnis herausgerechnet werden.

Bei der erfindungsgemäßen Vorgehensweise ist jedoch zu berücksichtigen, dass die Schrittweite ΔF des Frequenzwechsels, d.h. die Frequenzänderung von Frequenzpunkt f_{I} zum nächsten Frequenzpunkt f_{I+1} kleiner sein muss als die halbe Bandbreite des sich an die Mischer 10₁, 10₂, 14₁ und 14₂ jeweils anschließenden Zwischenfrequenzbereichs 80₁, 80₂, 80₃ und 80₄ der Messgeräte, denn wenn nur die Frequenzen der lokalen Oszillatoren, nicht jedoch die Anregungsfrequenzen geändert werden, ändert sich die Lage der Zwischenfrequenz IF. Dies ist anhand von Fig. 6 erläutert.

In Fig. 6 wird davon ausgegangen, dass die Frequenz f_{LO1} bzw. f_{LO2} der lokalen Oszillatoren LO1 bzw. LO2 größer ist als die Frequenzen f_{SO1} bzw. f_{SO2} der Signalgeneratoren SO1 bzw. SO2. Wird beim Übergang beispielsweise vom Frequenzpunkt f₁ und Frequenzpunkt f₂ zunächst die Frequenz f_{LO1} bzw. f_{LO2} der lokalen Oszillatoren LO1 bzw. LO2 erhöht (Schritt S1), so erhöht sich die Lage der Zwischenfrequenz um diese Frequenzschrittweite ΔF von IF zu IF + ΔF. Um sicherzustellen, dass das in seiner Zwischenfrequenzlage geänderte Signal noch empfangen werden kann, muss die Schrittweite der Frequenzänderung ΔF daher kleiner sein als die halbe Bandbreite 1/2 BW der Zwischenfrequenzbereiche 80₁ bis 80₄. Wird beim Schritt S2 dann anschließend auch die Frequenz f_{SO1} bzw. f_{SO2} der Signalgeneratoren SO1 bzw. SO2 verändert, so fällt die sich an den Mischern 10₁, 10₂, 14₁ und 14₂ ergebende Zwischenfrequenz IF wieder in die Mitte der Bandbreite BW der Zwischenfrequenzbereiche 801 bis 80₄.

Die bei der Netzwerkanalyse typischerweise verwendeten Frequenzschritte sind in der Regel deutlich kleiner als die Bandbreite der Zwischenfrequenzbereiche. Problematischer ist jedoch der Rücksprung von der Endfrequenz f_{N} zur Startfrequenz f₁. Dieser Rücksprung ist notwendig, da der Frequenz-Sweep bei der Messung in der Regel mehrfach durchgeführt wird und anschließend über die mehreren Messungen gemittelt wird. Der Rücksprung von f_{N} auf f₁ ist zwar nicht zeitkritisch, sollte jedoch nicht zulange dauern, um die Messung insgesamt nicht zulange zu verzögern.

Eine erste Lösung dieses Problems könnte darin bestehen, dass zwar einzelne Frequenzpunkte bei dem Rücksprung ausgelassen werden, aber noch so viele Zwischenwerte verwendet werden, dass sichergestellt wird, dass die Bandbreite der Zwischenfrequenzbereiche nicht verlassen wird.

Eine andere, effizientere Möglichkeit besteht darin, zunächst nur den ganzzahligen Anteil der Teilungsfaktoren der in Fig. 4 gezeigten Teiler 64, 67 und 77 der lokalen Oszillatoren LO1 bzw. LO2 zu verändern und den nicht ganzzahligen Anteil bzw. Nachkomma-Anteil F zunächst unverändert zu lassen. Wird bei den geschlossenen Regelschleifen der PLLs nämlich nur der ganzzahlige Anteil des Teilungsfaktors verändert, so ändert sich die Phasenlage am Ausgang jeder einzelnen PLL-Stufe (CHILD_PLL, SWEEP_PLL und MAIN_PLL) nicht, so dass dieser grobe Frequenzwechsel keinen Einfluss auf die Phasenlage des Ausgangssignals f_{LO1} hat. Genauso kann auch bei den Signalgeneratoren SO1 und SO2 vorgegangen werden.

Der jetzt noch verbleibende feine Frequenzwechsel, welcher der Anpassung des Nachkomma-Anteils F der Teilungsfaktoren der PLL-Synthesizer der lokalen Oszillatoren LO1 bzw. LO2 und der Signalgeneratoren SO1 bzw. SO2 entspricht, kann nun mit dem vorstehend erläuterten erfindungsgemäßen Verfahren geändert werden. Dabei wird, wie vorstehend geschildert, zunächst in einem ersten Teilschritt nur die Frequenz der lokalen Oszillatoren und dann anschließend in einem zweiten Teilschritt die Frequenz der Signalgeneratoren geändert. Die Schrittweite dieser noch verbleibenden feinen Frequenzänderung ist dann in der Regel so klein, dass diese kleiner als die halbe Bandbreite der Zwischenfrequenzbereiche ist und daher problemlos auf einmal vollzogen werden kann. Mit der vorstehend beschriebenen Erweiterung des erfindungsgemäßen Verfahrens gelingen daher auch größere Frequenzänderungen.

Ist der Einfluss des Messobjekts DUT auf die Auswertung aufgrund eines gut isolierenden, d.h. gut entkoppelnden, Richtkopplers 7₁ bzw. 7₂ gering, kann auch umgekehrt vorgegangen werden, d.h. es kann in einem ersten Schritt zunächst nur die Frequenz des Signalgenerators SO1 bzw. SO2 und in einem zweiten Schritt nur die Frequenz des lokalen Oszillators LO geändert werden.

Die Erfindung ist nicht auf das dargestellte Ausführungsbeispiel beschränkt. Insbesondere kommen als Messgeräte nicht nur Netzwerkanalysatoren, sondern auch andere Messgeräte wie Spektrumanalysatoren oder Oszilloskope in Betracht. Auch bezüglich Netzwerkanalysatoren kommen alternative Ausführungsbeispiele, insbesondere mit nur einem lokalen Oszillator LO1 bzw. LO2 für zwei oder mehrere Tore oder nur einem Signalgenerator SO1 bzw. SO2, welcher zwischen zwei oder mehreren Toren des Netzwerkanalysators umschaltbar ist, in Betracht. Auch die lokalen Oszillatoren LO können anders, als in Fig. 4 dargestellt, ausgestaltet sein. Die dem Verfahren zugrundeliegende bzw. vorausgehende Phasensynchronisation kann auch anders erfolgen, als dies anhand der Fig. 1 bis 3 beschrieben wurde, beispielsweise entsprechend der DE 103 31 092 A1.

## Patentansprüche

1. Verfahren zur Durchführung eines Frequenzwechsels unter Beibehaltung der Phasenbeziehung zwischen mehreren Geräten (NA1-NA4), insbesondere Netzwerkanalysatoren, wobei jedes Gerät (NA1-NA4) mindestens einen Signalgenerator (SO1;SO2) zur Anregung eines Messobjekts (DUT) und mindestens einen mit zumindest einem Mischer (10₁;10₂;14₁;14₂) verbundenen lokalen Oszillator (LO1;LO2) zum Empfang eines von dem Messobjekt erhaltenen Messsignals nach dem Überlagerungsprinzip aufweist,
**dadurch gekennzeichnet,**
**dass** bei einem Frequenzwechsel in einem ersten Schritt zunächst nur die Frequenz der lokalen Oszillatoren (LO1;LO2) aller Geräte (NA1-NA4) geändert wird und die Frequenz der Signalgeneratoren (SO1;SO2) aller Geräte (NA1-NA4) unverändert bleibt und in einem zweiten Schritt dann nur die Frequenz zumindest eines Signalgenerators (SO1;SO2) zumindest eines Geräts (NA1) geändert wird und die Frequenz der lokalen Oszillatoren (LO1;LO2) aller Geräte (NA1-NA4) unverändert bleibt oder
**dass** bei einem Frequenzwechsel in einem ersten Schritt zunächst nur die Frequenz zumindest eines Signalgenerators (SO1;SO2) zumindest eines Geräts (NA1) geändert wird und die Frequenz der lokalen Oszillatoren (LO1;LO2) aller Geräte (NA1-NA4) unverändert bleiben und in einem zweiten Schritt dann nur die Frequenz der lokalen Oszillatoren (LO1;LO2) aller Geräte (NA1-NA4) geändert wird und die Frequenz der Signalgeneratoren (LO1;LO2) aller Geräte (NA1-NA4) unverändert bleibt und dass die Signalgeneratoren (SO1;SO2) und die lokalen Oszillatoren (LO1;LO2) aller miteinander verbunden Geräte mit Hilfe von Phasensynchronisations-Einheiten (30) synchron zueinander sind und
**dass** vor und nach dem ersten Schritt eine exakte Messung der Phasenlage eines Messsignals (IF Meas1; IF Meas2) an dem Ausgang des Mischers (14₁;14₂) jedes Geräts (NA1-NA4) in Bezug auf die Phasenlage des von dem zugehörigen Signalgenerator (SO1;SO2) erzeugten Anregungssignals erfolgt und
**dass** die Differenz der Phasenlage vor und nach dem ersten Schritt durch Verstellen der Phasenlage des lokalen Oszillators (LO1;LO2) des jeweiligen Geräts und/oder des Signalgenerators (SO1;SO2) korrigiert wird oder
**dass** die Differenz der Phasenlage vor und nach dem ersten Schritt bei der Auswertung eingerechnet wird.

2. Verfahren nach dem Anspruch 1,
**dadurch gekennzeichnet,**
**dass** jeder lokale Oszillators (LO1;LO2) und jeder Signalgenerator (SO1;SO2) zumindest eine geschlossene Phasenregelschleife (65;66;73) mit zumindest einem Teiler (64;67;77) aufweist, der eine Frequenzteilung mit einem gebrochenrationalen Teilungsfaktor ((N,F)_{CH}, (N,F)_{SY}, (N,F)_{MA})) durchführt,
**dass** bei einem groben Frequenzwechsel zunächst der ganzzahlige Anteil (N) des Teilungsfaktors sowohl jedes lokalen Oszillators (LO1;LO2) als auch des zumindest einen Signalgenerators (SO1;SO2) geändert wird und
**dass** bei einem anschließenden feinen Frequenzwechsel in einem ersten Schritt zunächst nur der nichtganzzahlige Anteil (F) des Teilungsfaktors jedes lokalen Oszillators (LO1;LO2) geändert wird und der nichtganzzahlige Anteil (F) des Teilungsfaktors des zumindest einen Signalgenerators (SO1;SO2) unverändert bleibt und in einem zweiten Schritt dann nur der nichtganzzahlige Anteil (F) des Teilungsfaktors des zumindest einen Signalgenerators (SO1;SO2) geändert wird und der nichtganzzahlige Anteil (F) des Teilungsfaktors aller lokalen Oszillatoren (LO1;LO2) unverändert bleibt, oder
**dass** bei einem anschließenden feinen Frequenzwechsel in einem ersten Schritt zunächst nur der nichtganzzahlige Anteil (F) des Teilungsfaktors des zumindest eines Signalgenerators (SO1;SO2) geändert wird und der nichtganzzahlige Anteil (F) des Teilungsfaktors aller lokalen Oszillatoren (LO1;LO2) unverändert bleibt und in einem zweiten Schritt dann nur der nichtganzzahlige Anteil (F) des Teilungsfaktors jedes lokalen Oszillators (LO1;LO2) geändert wird und der nichtganzzahlige Anteil (F) des Teilungsfaktors des zumindest eines Signalgenerators (SO1;SO2) unverändert bleibt.

3. Verfahren nach einem der Ansprüche 1 oder 2,
**dadurch gekennzeichnet,**
**dass** die Schrittweite (ΔF) des Frequenzwechsels beim zweiten Schritt kleiner als die halbe Bandbreite (BW) eines sich an die Mischer (10₁; 10₂; 14₁; 14₂) jeweils anschließenden Zwischenfrequenzbereichs (80₁-80₄) ist.

## Claims

1. Method for carrying out a frequency change while retaining the phase relationship between a plurality of devices (NA1-NA4), in particular network analysers, wherein each device (NA1-NA4) comprises at least one signal generator (SO1; SO2) for excitation of a device under test (DUT) and at least one local oscillator (LO1; LO2) connected with at least one mixer (10₁; 10₂; 14₁; 14₂) for reception of a measurement signal received from the device under test by the heterodyne principle,
**characterised in that**
when a frequency change occurs, in a first step initially only the frequency of the local oscillators (LO1; LO2) of all the devices (NA1-NA4) is changed and the frequency of the signal generators (SO1; SO2) of all the devices (NA1-NA4) remains unchanged, and in a second step then only the frequency of at least one signal generator (SO1; SO2) of at least one device (NA1) is changed and the frequency of the local oscillators (LO1; LO2) of all the devices (NA1-NA4) remains unchanged or
**in that** when a frequency change occurs, in a first step initially only the frequency of at least one signal generator (SO1; SO2) of at least one device (NA1) is changed and the frequency of the local oscillators (LO1; LO2) of all the devices (NA1-NA4) remains unchanged and then in a second step only the frequency of the local oscillators (LO1; LO2) of all the devices (NA1-NA4) is changed and the frequency of the signal generators (LO1; LO2) of all the devices (NA1-NA4) remains unchanged and
**in that** the signal generators (SO1; SO2) and the local oscillators (L01; L02) of all the interconnected devices are synchronised with one another with the aid of phase synchronisation units (30) and
**in that** before and after the first step an exact measurement is made of the phase position of a measurement signal (IF Meas1; IF Meas2) at the output of the mixer (14₁; 14₂) of each device (NA1-NA4) in relation to the phase position of the excitation signal generated by the associated signal generator (SO1; SO2) and
**in that** the difference in the phase position before and after the first step is corrected by adjusting the phase position of the local oscillator (LO1; LO2) of the respective device and/or of the signal generator (SO1; SO2) or
**in that** the difference in the phase position before and after the first step is taken into account in the evaluation.

2. Method according to claim 1,
**characterised in that**
each local oscillator (LO1; LO2) and each signal generator (SO1; SO2) comprises at least one closed phase locked loop (65; 66; 73) with at least one divider (64; 67; 77) which carries out a frequency division with a fractional rational division factor ((N.F)_{CH}, (N.F)_{SY}, (N.F)_{MA}),
**in that** in the case of a rough change in frequency initially the integer component (N) of the division factor both of each local oscillator (LO1; LO2) and of the at least one signal generator (SO1; SO2) is changed and
**in that** in the case of a subsequent fine change in frequency in a first step initially only the non-integer component (F) of the division factor of each local oscillator (LO1; LO2) is changed and the non-integer component (F) of the division factor of the at least one signal generator (SO1; SO2) remains unchanged and in a second step then only the non-integer component (F) of the division factor of the at least one signal generator (SO1; SO2) is changed and the non-integer component (F) of the division factor of all the local oscillators (LO1; LO2) remains unchanged, or
**in that** in the case of a subsequent fine change in frequency in a first step initially only the non-integer component (F) of the division factor of the at least one signal generator (SO1; SO2) is changed and the non-integer component (F) of the division factor of all the local oscillators (LO1; LO2) remains unchanged and in a second step then only the non-integer component (F) of the division factor of each local oscillator (LO1; LO2) is changed and the non-integer component (F) of the division factor of the at least one signal generator (SO1; SO2) remains unchanged.

3. Method according to one of claims 1 or 2,
**characterised in that**
the step width (ΔF) of the change in frequency in the second step is smaller than half the band width (BW) of an intermediate frequency range (80₁-80₄) in each case adjacent to the mixers (10₁; 10₂; 14₁; 14₂).

## Revendications

1. Procédé pour réaliser un changement de fréquence en maintenant la relation de phase entre plusieurs appareils (NA1 à NA4), en particulier des analyseurs de réseau,
dans lequel chaque appareil (NA1 à NA4) comporte au moins un générateur de signaux (SO1 ; SO2) pour exciter un objet de mesure (DUT) et au moins un oscillateur local (LO1 ; LO2) relié à au moins un mélangeur (10₁ ; 10₂ ; 14₁ ; 14₂) pour recevoir un signal de mesure reçu par l'objet de mesure selon le principe de superposition,
**caractérisé en ce que**
en cas de changement de fréquence, à une première étape, changer tout d'abord uniquement la fréquence des oscillateurs locaux (LO1 ; LO2) de tous les appareils (NA1 à NA4) et maintenir la fréquence des générateurs de signaux (SO1 ; SO2) de tous les appareils (NA1 à NA4) inchangée et, à une seconde étape, changer ensuite uniquement la fréquence d'au moins un générateur de signaux (SO1 ; SO2) d'au moins un appareil (NA1) et maintenir la fréquence des oscillateurs locaux (LO1 ; LO2) de tous les appareils (NA1 à NA4) inchangée ou
en cas de changement de fréquence, à une première étape, changer tout d'abord uniquement la fréquence d'au moins un générateur de signaux (SO1 ; SO2) d'au moins un appareil (NA1) et maintenir la fréquence des oscillateurs locaux (LO1 ; LO2) de tous les appareils (NA1 à NA4) inchangée et, à une seconde étape, changer ensuite uniquement la fréquence des oscillateurs locaux (LO1 ; LO2) de tous les appareils (NA1 à NA4) et maintenir la fréquence des générateurs de signaux (LO1 ; LO2) de tous les appareils (NA1 à NA4) inchangée et
synchroniser mutuellement les générateurs de signaux (SO1 ; SO2) et les oscillateurs locaux (LO1 ; LO2) de tous les appareils reliés les uns aux autres à l'aide d'unités de synchronisation de phase (30) et
avant et après la première étape, réaliser une mesure précise de la position de phase d'un signal de mesure (IF Meas1 ; IF Meas2) à la sortie du mélangeur (14₁ ; 14₂) de chaque appareil (NA1 à NA4) par rapport à la position de phase du signal d'excitation généré par le générateur de signaux (SO1 ; SO2) associé et
corriger la différence de position de phase avant et après la première étape en réglant la position de phase de l'oscillateur local (LO1 ; LO2) de l'appareil et/ou du générateur de signaux (SO1 ; SO2) respectif ou
lors de l'évaluation, inclure la différence de position de phase avant et après la première étape.

2. Procédé selon la revendication 1,
**caractérisé en ce que**
chaque oscillateur local (LO1 ; LO2) et chaque générateur de signaux (SO1 ; SO2) comporte au moins une boucle fermée à phase asservie (65 ; 66 ; 73) avec au moins un diviseur (64 ; 67 ; 77) qui réalise une division de fréquence avec un facteur de division ((N,F)_{CH}, (N,F)_{SY}, (N,F)_{MA}) fractionnaire-rationnel,
en cas de changement de fréquence grossier, la partie entière (N) du facteur de division aussi bien de chaque oscillateur local (LO1 ; LO2) que du au moins un générateur de signaux (SO1 ; SO2) est tout d'abord changée et
en cas de changement de fréquence fin ultérieur, à une première étape, seule la partie non entière (F) du facteur de division de chaque oscillateur local (LO1 ; LO2) est tout d'abord changée et la partie non entière (F) du facteur de division du au moins un générateur de signaux (SO1 ; SO2) reste inchangée et, à une seconde étape, seule la partie non entière (F) du facteur de division du au moins un générateur de signaux (SO1 ; SO2) est ensuite changée et la partie non entière (F) du facteur de division de tous les oscillateurs locaux (LO1 ; LO2) reste inchangée, ou
en cas de changement de fréquence fin ultérieur, à une première étape, seule la partie non entière (F) du facteur de division du au moins un générateur de signaux (SO1 ; SO2) est tout d'abord changée et la partie non entière (F) du facteur de division de tous les oscillateurs locaux (LO1 ; LO2) reste inchangée et à une seconde étape, seule la partie non entière (F) du facteur de division de chaque oscillateur local (LO1 ; LO2) est ensuite changée et la partie non entière (F) du facteur de division du au moins un générateur de signaux (SO1 ; SO2) reste inchangée.

3. Procédé selon l'une des revendications 1 ou 2,
**caractérisé en ce que**
la largeur de pas (ΔF) du changement de fréquence à la seconde étape est inférieure à la demie largeur de bande (BW) d'une plage de fréquences intermédiaires (80₁ à 80₄) respectivement adjacente aux mélangeurs (10₁ ; 10₂ ; 14₁ ; 14₂) .
